# EUROPEAN PATENT SPECIFICATION

(11) **EP 3 815 879 B1**
(45) Date of publication and mention of the grant of the patent: **24.05.2023**
(21) Application number: 20204181.0
(22) Date of filing: 27.10.2020
(51) Int. Cl.: B29C 64/124, B29C 64/255, B29C 64/321, B29C 64/357, B33Y 10/00, B33Y 30/00, B29C 64/129, B29C 64/264, B29C 64/286, G03F 7/00

(54) **METHOD OF 3D PRINTING IN A CHAMBER OF ADJUSTABLE VOLUME USING LCD SCREENS AS THE METHOD OF POLYMERISATION**
VERFAHREN ZUM 3D-DRUCKEN IN EINER KAMMER MIT EINSTELLBAREM VOLUMEN UNTER VERWENDUNG VON LCD-BILDSCHIRMEN ALS VERFAHREN ZUR POLYMERISATION
PROCÉDÉ D'IMPRESSION 3D DANS UNE CHAMBRE DE VOLUME AJUSTABLE UTILISANT DES ÉCRANS LCD COMME PROCÉDÉ DE POLYMÉRISATION

(30) Priority: 28.10.2019 GB 201915591
(43) Date of publication of application: 05.05.2021
(73) Proprietor: PhotoCentriC Limited, Peterborough Cambridgeshire PE1 5YW (GB)
(72) Inventor: HOLT, Paul, Peterborough, Cambridgeshire PE1 5YW (GB)
(74) Representative: HGF

(56) References cited:
- EP-A1- 3 354 442
- EP-A1- 3 643 479
- CN-A- 109 483 882

## Description

### TECHNICAL FIELD

This invention relates to the field of stereolithographic (SLA) 3D printing using liquid crystal display (LCD) screens as the selective digital illumination device and describes methods that adjust the volume of the build container during printing. This invention allows the inside of the print chamber to be pressurised. It further allows the process of printing an object to carried out entirely without the influence of gravity. It has benefits when printing conventionally on Earth in reducing the peeling forces that are present at the moment of delamination of the object from the separation surface protecting the screen. Consequently, when printing in space or conventionally on Earth, it enables printing with minimal peel forces which leads to faster printing, less delamination lines, less warpage from build forces and the ability to use finer support tips.

### BRIEF SUMMARY OF THE INVENTION

This invention describes a method enabling the sequential adjustment in volume of the build chamber in SLA based 3D printing where the method of polymerisation is to use LCD screens to selectively harden the photopolymer contained within it. This method of printing enables the printer to be orientated in any direction and to print without recourse to gravity necessary to re-level the photopolymer during the printing process. The contents can be pressurised during printing.

Conventionally 3D printers can print in two orientations, with the screen at the bottom and with the screen at the top, in either case gravity levels the upper surface of the photopolymer in a containment vat. In smaller format printing the most common method is to have the resin contained in a vat which rests on the illumination source, this is termed `bottom-up printing' here the platform elevates away from the base of the vat and each time it moves up, a force is created as the lower surface of the recently made part disengages from the vat. In larger format printers, most commonly the illumination source is at the top, termed `top-down printing' and the platform lowers away from the light source one layer on the screen and each time it moves down. Here there is a force created as the upper surface of the recently made part disengages from the protective film protecting the light source, or alternatively it can configured so that there is an air gap between the light source and the photopolymer and which case there are no delamination or peeling forces.

Such delamination forces can be substantially reduced and better controlled if the print chamber is enclosed and the photopolymer liquid is pushed into the chamber, rather than conventionally where the force is applied to the build platform causing it to move, and thus the photopolymer is pulled into the cavity between the built object and the protective surface. This invention describes a novel construction of LCD driven 3D printers that controls the build speed and layer thickness by the flow of liquid photopolymer, rather than by delivering force to the platform up and down.

### BACKGROUND

Three-dimensional (3D) printing, also known as rapid prototyping or additive manufacturing, is a method of forming 3D objects by building up sequential layers, each defined using a respective digital representation. The digital representations may be formed by scanning a physical object in three-dimensions or may be formed by digitally sectioning a three-dimensional computer-aided design (CAD) image. Typically, the layers are of equal thicknesses.

In SLA printing the printer builds 3D objects from successive layers of selectively polymerised liquid photosensitive polymer (resin), also referred to as photopolymer. The liquid photopolymer is polymerised (hardened) by an electromagnetic radiation exposure of an appropriate wavelength, e.g. visible light or near ultraviolet light.

To form a 3D printed object by stereolithographic 3D printing, a selective illumination of electromagnetic radiation is provided from an imaging source to form each layer, with the first layer being formed on a build platform, before the separation between the build platform and imaging source is increased by the thickness of a layer, and the next layer of selective polymerisation is formed attached to the preceding layer. The process of selective exposure and separation is repeated until the complete 3D printed object has been constructed.

Prior to the introduction of LCD screens, photopolymer was selectively hardened by light emitted from a laser or by focusing the light from a digital light processing (DLP) projector emitted through its digital mirror device onto either the upper or lower layer of resin in a vat. This invention relates to the field of 3D printing where the image source is a visual display screen, most typically an LCD screen. It has recently become widely used by many manufacturers who have incorporated the screens as the digital mask to deliver custom polymerisation. LCD screens are particularly attractive as a driver for image creation in 3D printers because they are mass manufactured consumer items and are therefore available at very low cost. Furthermore, they generate very high-resolution images driven by the demand for higher and higher image quality on these devices. They also expose an entire layer of the vat simultaneously with relatively even light distribution without any requirement to refocus the light through a lens. They are available in a wide variety of formats from the very small screens used in near-eye virtual reality headsets, through mobiles, tablets, monitors to TV screens. They are simpler to manufacture than competitive technologies. In the case of a laser 3D printer complex electronics and galvanometers are required, or in the case of a DLP printer a lens is often required to refocus the widening light beam back onto a smaller area. In contrast visual display screen device-based 3D printers are effectively composed from just an electronic driver board, a linear drive, a resin containment vat, a visual display screen and optionally a modified light generation source. In small format, when using mobile phone screens and the like, the printers can perform reasonably reliably, but when large screens are used, the forces at the build interface as the polymer is detached from the vat film can be large and lead to the print failing. This invention describes a novel configuration of such a printer so that the build chamber is sealed and not open to the atmosphere. In such a manner the build chamber is sequentially enlarged as the print progresses and holds both polymerised object and liquid photopolymer.

Previous methods are described as follows; WO 2018/186849 to Zamorano et al describes a method for forcing photopolymer into the build chamber to cool the photopolymer.

EP3354442 A1 discloses an apparatus for producing objects by stereolithography and a method for producing objects by stereolithography. The disclose relates to a cartridge comprising a transparent wall, a movable platform and an extensible shell wall that delimit in a sealed manner a chamber containing the resin necessary to produce only one predetermined object as well as a method for manufacturing said object.

CN109483882 A discloses a light curing 3D printing system and a light curing 3D printing method.

EP3643479 A1 discloses a method and device for building a shaped body by stereolithographic curing of building material by photopolymerization.

### SUMMARY OF THE DISCLOSURE

According to a first aspect; there is provided a stereolithographic 3D printer according to claim 1.

Aptly, the print platform and visual display screen are positioned within an interior of the build vessel (that is, the build chamber is defined within an interior of the build vessel). The volume within the build chamber is sealed. For example, the print platform or visual display screen may extend across the build vessel, the periphery of the print platform or visual display screen being sealingly engaged with the at least one side wall of the build vessel. As such, the build chamber is defined by, or bounded by, the at least one side wall, the print platform and the visual display screen (one of which may be included on a base portion of the build vessel, or used as the base portion of the build vessel).

The print platform may move within the build vessel relative to the visual display screen, or vice versa, to change the volume of the build chamber. That is, the print platform or visual display screen may be moved to change the boundary or bounding portions of the build chamber and hence change the volume therein.

Aptly, the visual display screen or the print platform, and optionally also the valve, are located in a base of the build vessel. For example, the visual display screen may emit light at the base of the build vessel.

Aptly, the photopolymer is delivered into the build chamber by pressure on the reservoir chamber containing the photopolymer. The reservoir chamber may be sealed (that is, the reservoir chamber may be a sealed compartment of adjustable volume within the reservoir vessel). The photopolymer within the reservoir chamber may be pressurised by a piston, which acts to reduce the volume of the reservoir chamber.

Aptly, the build chamber does not have an air blanket covering the photopolymer during the build process. That is, during the build process the volume of the build chamber corresponds to, or is substantially equal to, the volume of the photopolymer within the build chamber. Aptly, the print platform is movable within the build vessel and creates a seal at its perimeter. Aptly, the visual display screen is movable within the build vessel and creates a seal at its perimeter.

Aptly, the build chamber volume is freely adjustable through the free movement of the print platform or visual display screen within the build vessel. That is, the print platform or visual display screen are free to move in response to an increase in pressure in the reservoir chamber. Aptly, the build layer thickness corresponds to the increase in build chamber volume (that is, the build layer thickness can be controlled by controlling the increase of volume of the build chamber, as this increases the separation between the print platform and the visual display screen).

Aptly, the visual display screen is an LCD screen. Aptly, the LCD screen is illuminated by an LED backlight.

Aptly, the visual display screen enables the passage of visible or near-visible UV light.

Aptly, the photopolymer is a particle rich slurry.

Aptly, the particles are metal. Aptly, the particles are ceramic.

Aptly, the 3D printer comprises a further valve located in the at least one side wall, configured to allow a fluid to enter the build chamber, wherein, in use, entry of the fluid into the build chamber forces photopolymer from the build chamber into the reservoir chamber. In other words, the photopolymer can be removed by opening the further valve to enable a gas to enter.

Aptly, the further valve is configured so that it can allow entry of a fluid into the build chamber when the build chamber reaches a predetermined volume (for example corresponding to a completed build). In some examples, the further valve is positioned such that during the build it is located outside of the build chamber but once the build is complete it is positioned inside the build chamber. For example, the further may be positioned at the top of the build vessel side wall (i.e. at the opposite end of the build vessel to the valve). In other examples, the further valve may be located within the build chamber at all times and only opened once the build is complete.

Aptly, the build chamber can be filled with a wash fluid to solubilise the photopolymer.

Aptly, the build chamber can be filled with water or gas to enable the part to be post exposed in the same chamber.

Aptly, the same display screen that exposed the photopolymer to create the object can be used to post-expose the object, whether under water or gas.

According to a second aspect; there is provided a method for creating 3D objects, the method comprising creating a 3D object in a build chamber of variable dimensions, the volume of which can be increased sequentially.

Aptly, the method comprises:
providing a 3D printer according to any of the first aspect of the invention;
exposing a layer of photopolymer within the build chamber to light emitted by the visual display screen;
increasing the volume of the build chamber sequentially;
exposing a further layer of photopolymer within the build chamber to light emitted by the visual display screen.

The steps of the method may be repeated to build successive layers of the 3D object as required.

Aptly, the volume of the build chamber is increased by allowing photopolymer to enter the build chamber from the reservoir chamber. Aptly, the photopolymer is pumped into the build chamber from the reservoir chamber, for example by reducing the volume of the reservoir chamber (e.g. by a piston action).

Aptly, the method further comprises allowing a pressurised gas into the build chamber to force photopolymer from the build chamber into the reservoir chamber.

Aptly, the method further comprises filling the build chamber with a wash fluid to solubilise the photopolymer.

Aptly, the method further comprises filling the build chamber with water or gas to enable the part to be post exposed in the same chamber.

### DESCRIPTION OF THE DRAWINGS

Examples are further described hereinafter with reference to the accompanying four drawings showing the different steps of its operation, in which:
Fig. 1 shows the novel apparatus where the printing process is about to start, with a fully charged resin reservoir and an empty build chamber;
Fig. 2 shows the printing process underway with the reservoir chamber partly lowered and the build chamber comprising of both liquid resin and solidified resin (object).
Fig. 3 shows the printing process completed with a lowered reservoir chamber and the part fully built in the chamber still comprising of both solidified and liquid resin and the platform extended above the second relief valve;
Fig. 4 shows the end of the process with the print chamber now evacuated of liquid resin as gas has been allowed in through the upper valve to force the excess resin back into the resin reservoir.

### DETAILED DESCRIPTION

The photopolymer described in this invention can be cured either by a radical, or a cationic polymerisation mechanism, or a combination thereof. It can be a polyurethane, polycarbonate, epoxy based or any other form of chemistry. The photopolymer formulation comprises at least one monomeric or oligomeric chemical species comprising at least one carbon-carbon double bond that is polymerizable by free radical polymerisation. The oligomeric or monomeric species is present in a total amount of 10-95 wt%; alternatively, the monomeric or oligomeric species may contain a heterocylic species, preferably an oxygen containing heterocycle, polymerizable by cationic polymerization. The oligomeric or monomeric species is present in a total amount of 10-95 wt%. There will be at least one photoinitiator that absorbs light in the region between 350 - 700 nm. The photoinitiator will be present at 0.1-10 wt% and at least one co-initiator may be present in a total amount of 0.1-20 wt%. Optionally, the photopolymer formulation may contain a plurality of particles, a pigment or dye. Optionally, the photopolymer formulation may contain a dispersing or flow-modifying agent.

The visual display screen or emissive pixel array may be of the following types; Liquid Crystal Display (LCD), Light emitting Diode (LED), Electronic paper (E Ink), Electroluminescent display (ELD), Plasma Display Panel (PDP) or Organic Light-emitting Diode Display (OLED). This list is not limiting in its scope in terms of the invention and indeed any device which emits digitally controllable light can be used in this invention, the preferred choice of visual display screen however is LCD in format. For simplicity we will use the term LCD screen to refer to the visual display screen used in a non-limiting manner afterwards.

An LCD typically consists of an array of pixels. Each pixel consists of a layer of liquid crystal molecules aligned between two transparent electrodes and two polarizing filters (parallel and perpendicular), the axes of transmission of which are, in most of the cases, perpendicular to each other. Before an electric field is applied, the orientation of the liquid crystal molecules is commonly twisted, the surface alignment directions at the two electrodes are perpendicular to each other and so the molecules arrange themselves in a helical structure. By controlling the voltage applied across the liquid crystal layer in each pixel, light can be allowed to pass through in varying amounts thus creating different levels of light transmission.

It may be that the visual display screen has 500 pixels per inch (197 pixels per cm) or greater, in practice the higher the pixel density the greater the object resolution. It may be that the visual display screen has a ratio of its contrast ratio to its luminescence that is above 1.0, in practice the greater the contrast ratio the easier to prevent curing across the screen when the screen is black.

The length of time that the screen illuminates the image is determined by two factors; the rate of curing of the photopolymer and the intensity of light being emitted from the screen thus curing it. It is therefore desirable to reduce the exposure time by increasing the intensity of the light transferred through the array.

In some cases, this type of visual display screen based 3D printer utilises the screen as it was intended, but in most cases the 3D printer manufacturer removes the backlight and rear panel and illuminates it directly from behind the array. Commonly the LCD screen assembly has its LED backlight which generated visible light from 400 nm to 700 nm replaced with LEDs directly behind the array emitting light that is as collimated as possible. This in effect uses the LCD nematics as an array of individually controllable masks that either untwist and allow the light through, or remain twisted to prevent it. The screens can be monochrome or colour and composed of sets of blue, green and red subpixels or other colours. The intensity can be much brighter than would be intended for human viewing where typically 350-500 nits (candela/m²) is used for normally lit environments and 800-1000 nits is used for sunlit ones, in practice there is no limit to light emitted from the array, it being dependent upon the power of the lighting array behind it, the loss in contrast ratio as the intensity is increased and the maximum tolerable level of heat or UV for the screen or the resin. LCD screens are reliable and if lit at the correct wavelength, intensity and in the absence of significant UV and heat are very long lasting, generating reliable images for over 30,000 hours, far longer than lasers or DLPs.

In the described examples, the following standard apparatus was used, the 3D printer comprises of an LCD screen that was a 5.7" (14.5 cm) 2160x3840 pixel LCD array in RGB format from BOE in Beijing, China, part number VS057QUM-NH2-62P0. It was back lit with a lensed LED array consisting of 38 x 3W LEDs with peak emission of 410 nm with each LED fitted with individual 12-degree angle of incidence collimating lenses on top of them. It is possible to use a UV or visible light source with the peak wavelength of between 350 nm to 700 nm, it is also possible for the LCD array to be back-lit by two arrays that can emit at different wavelengths to selectively harden two different polymers to deliver different properties to them. The LCD screen can be optionally backlit by an array of collimated or near-collimated light of solely UV, a mixture of UV and visible or solely visible light.

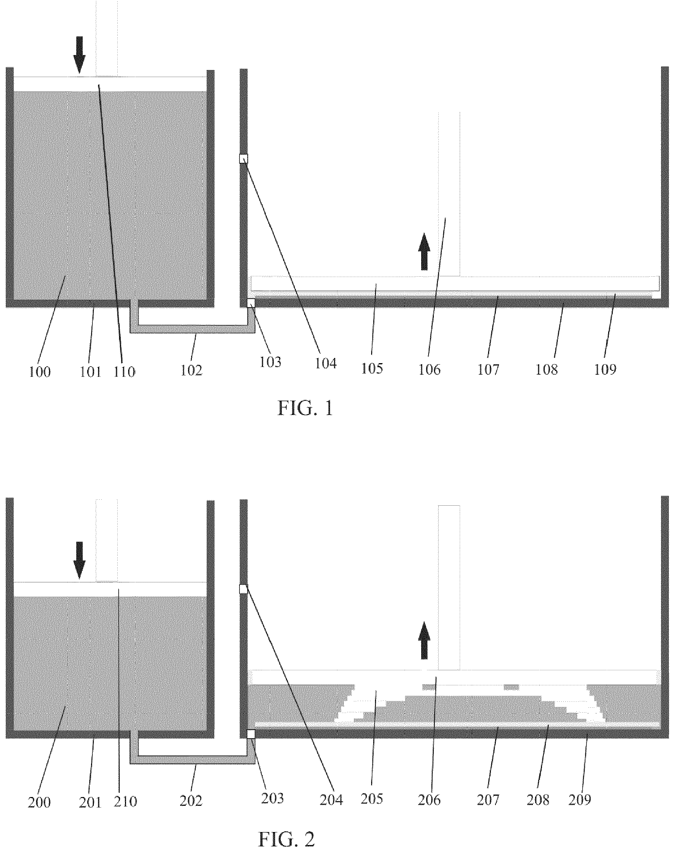

Fig. 1 shows the first step of this process. At this position the print platform (105) is in contact with the surface, typically a protective film covering the LCD screen (107). The platform can be moved away from the screen by either delivering upwards force to the arm (106) or by delivering downward force to the piston attached to the platform (110) in the resin reservoir chamber adjacent and connected to it. The resin (100) is forced into the transfer pipe (102), via the base valve (103) positioned in the base of the print cylinder, or build vessel (108). There is an additional upper release valve at the top of the chamber (101) (in particular located towards an upper end of a side wall of the chamber 101). The resin is pumped in to achieve the desired thickness of layer, for instance 100 microns across the entire cylinder area. The platform (105) is then forced to lift by a height determined by the volume of resin that has entered the chamber, which will become the build layer thickness. The screen can be protected by a very low energy surface coating or film (109) on the inner surface to reduce adhesion of the layer to the screen after printing. For example, the layer (109) may be a coating or film of Polymethylpentene (PMP), Fluorinated Ethylene Propylene (FEP), Perfluroalkoxy (PFA), Ethylene Chlorotrifluoroethylene (ECTFE), Polyvinylidene Fluoride (PVDF), Polypropylene (PP), or polyester (PET). Alternatively, the covering of the LCD screen may comprise a coating of silanes, silicones, silsesquioxanes or the like. For example, the LCD may be covered in a substrate of thin sheet glass provides with a surface coating of silicone, e.g. Polydimethylsiloxane (PDMS), for example Sylgard^{®} 184 manufactured by Dow Chemical company. The same low energy surface coating (109) can be applied to the surfaces of the platform that move against the inner walls of the build chamber both reduce friction and repel liquid.

Fig. 2 shows the process during building. Here the position the print platform (206) is part way up the build chamber (209) with the low surface energy protective film (208) covering the LCD screen (207). The platform has been forced upwards by a force applied to the platform (210) in the resin reservoir chamber (201), forcing resin (200) through the transfer pipe (202) through the base valve (203) positioned in the bottom of the build chamber. The upper valve (204) is above the build chamber print platform (206). The object (205), consisting of polymerised resin, is surrounded by unpolymerized resin (200) at this stage.

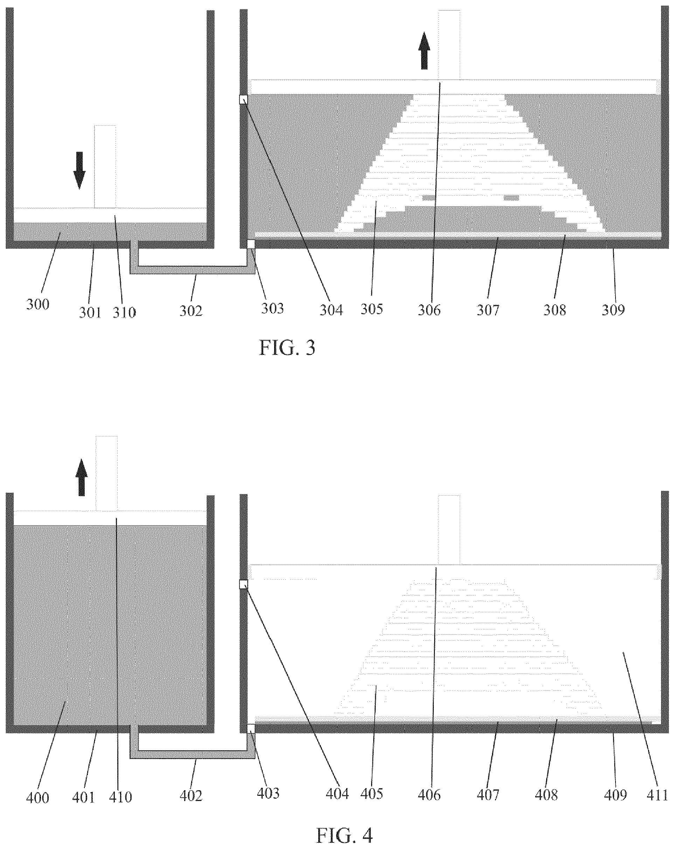

Fig. 3 shows the process when building the object (305) is complete. In this position the print platform (306) is fully elevated in the build chamber (309). There is a low surface energy protective film or coating (308) covering the LCD screen (307). The platform has been forced upwards by a force applied to the platform (310) in the resin reservoir chamber of the reservoir vessel (301), forcing the resin (300) through the transfer pipe (302) through the base valve (303) positioned in the bottom of the build chamber. The upper valve (304) is now below the build chamber print platform (306). The object (305), consisting of polymerised resin, is surrounded by unpolymerised resin (300) at this stage.

Fig. 4 shows the process when building the object (405) is complete. Here the position the print platform (406) is fully elevated in the build chamber (409). There is a low surface energy protective film or coating (408) covering the LCD screen (407). The build platform (406) remains elevated above the upper air release valve (404) through which has entered under air pressure or at elevated pressure. The liquid resin (400) has been forced back through the base valve (403) positioned in the bottom of the build chamber (409) down the transfer pipe (402) into the resin reservoir chamber (401). The object (405) consists of polymerised resin, surrounded by a thin coating of resin (400) with the rest of the build chamber (409) filled with air (411) or another gas.

This invention has thus described a novel method of 3D printing using photopolymer illuminated by predominantly visible light emitted through a visual display screen, preferably an LCD screen. The process involves creating a sealed build chamber which has a retractable build platform which moves away from the LCD screen, retracting layer by layer as the object is built. The increasing volume in the chamber is filled by pumping in photopolymer filled in from an adjoining reservoir via a valve. In an alternative configuration it is possible to make the display screen and optionally a back-light configuration illuminating it to move instead of the build platform inside the chamber.

The process of printing is as follows; the print platform starts in contact with the screen or optionally a protective film covering the screen. The screen can be selected to fit the size of the chamber, it can be any shape that is large than the external footprint of the objects required to be built, but is preferably rectangular, square or circular. For convenience a cylinder can be used with a standard piston that seals inside it. The screen can be any form of visual display screen of any size or shape, but preferably it is an LCD screen. It can be of any resolution or pixel pitch, but preferably it is of the highest resolution possible for that format, for instance 4K, or 4,000 pixels across the x axis or more desirably 8K or 8,000 pixels across the x axis or even higher resolutions. The screen maybe be used as it was intended, with the light emitted being optimised in intensity for the viewing by the human eye, or it could be preferably illuminated with an increased intensity of light emitted from a purpose built back light unit. The backlight is preferably an array of LED which emit near-collimated light at a narrow angle of emission, preferably less than 20° to the vertical, more preferably less than 10° to the vertical, or most desirably 5° to the vertical. The light can have an emission spectrum anywhere that matches the peak of the photo-reactivity of the photopolymer, but most desirably it is predominantly visible light, more desirably blue light, ie between 400nm and 460nm. It is convenient to allow some UV through the visual display screen if the photoinitiators used in the photopolymer are activated in that region, such as those containing phosphine oxides. Thus, the illumination may extend down towards 380nm and even shorter in wavelength.

The first part of the printing process is to allow photopolymer to enter the chamber through the valve from the adjoining cylinder containing it. The cylinder containing the photopolymer can be pressurised by virtue of force being applied to a piston that makes a seal within the photopolymer containment cylinder. A valve at the base of the build chamber can be opened to allow the photopolymer to enter the build chamber. As the resin is forced into the build chamber, the build chamber platform will be forced further back in the chamber away from the screen. The build chamber platform can also be connected to a piston which can aid the retraction of the platform by applying a retractive force, alternatively this build platform can be not driven with force at all and can be free to be positioned anywhere according to the opposing forces of air pressure and resin pressure either side of it. In this manner the platform can be free flowing and the position of it can be determined solely by the level of force applied from the photopolymer cylinder. In another embodiment of this invention the piston in the build chamber can be allowed to retract by set distances configured by gears or some other mechanical means such that the piston steps back by distances that are the same each time, those distances defining the layer build height. After the intended amount of photopolymer has been forced into the build chamber, the build platform (or the base layer of the object built upon the build platform) is separated from the screen by the layer height.

The second part of the printing process is the exposure of this layer of photopolymer to light emitted through the LCD screen. To enable a low level of adhesion between the cured photopolymer and the screen it can be desirable to cover the screen in a low energy film such as FEP film. The light is selectively illuminated, in that certain pixels are designated to be open, by which the liquid crystal nematics untwist to allow light through and that certain pixels are designated to be closed, in that the nematics remain twisted and light in not emitted from them. The image created by the LCD screen represents one layer of the slices that make up the object's shape. The light is illuminated for the length of time necessary to completely harden the photopolymer to the desired thickness, being the layer thickness. Typically, the layer thickness is 25µm, 50µm, 100µm or even thicker.

The third part of the printing process is to pump more photopolymer in to create the next layer, typically the volume of photopolymer injected is the same each time and the layer height is therefore the same each time. However, in the case that the print is largely unchanging along its z-axis direction, thicker layers can be made by injecting more resin through and exposing for a longer time to speed the build process up.

The fourth part of the printing process is when the object build is complete and air (or other gaseous medium) is allowed into the build chamber via a valve positioned at the top of the chamber to allow resin to be removed via the same valve it entered the chamber, positioned at the opposite end, in the base. To enable this air can be drawn into the chamber by reversing the motion of the piston in the resin reservoir chamber and lifting it to retract the resin while air enters through the air release valve. Alternatively, the air can be pumped in. When the process is complete, the object, still covered in a thin coating of liquid resin, will be surrounded in the chamber by air. Most of the liquid resin will now have returned to the resin reservoir chamber from where it originally came.

The final part of the process is to remove the platform and perform washing and post processing. The finished object is removed from the build chamber and washed. In this case the part is washed in Photocentric Resin Wash in an ultrasonic cleaning machine for 10 minutes. The part was then post exposed under a combination of UV and visible light for 60 minutes in a Photocentric Cure Box. A solid object representing the digital image displayed in sections on the LCD screen was satisfactorily created.

All the aforementioned process can be controlled by computer to allow valves to open and close and pistons to lower and retract in the desired sequence.

A further embodiment of this invention is to carry out the washing and post exposing functions in the same build chamber. This can be performed by having two additional separate reservoirs connected to the build chamber, one to hold resin cleaning fluid and the other to hold rinsing water. In such a manner the build chamber can be filled with wash fluid through a separate valve filled in the base of the chamber and during this process air can be allowed to evacuate via the upper valve. To ensure thorough washing this process can be repeated several times. When the part is completely clean, the wash fluid can be retracted back into the cylinder from whence it came by allowing air back into the chamber via the valve at the top. A further similar process with a separate rinse tank of water ensures that the resin cleaning fluid is completely removed. The water can now be left in the build chamber to post expose under water without gas (to prevent oxygen inhibition of the polymerisation process) or alternatively it can be post exposed dry with the water returned to the cylinder from whence it came. The LCD screen that selectively opened to light from the LED backlight during its build process can now be entirely opened to light from the backlight to immerse the object in light and enable post exposure. Optionally the exterior walls of the build chamber can be heated to deliver more effective post exposure. In an alternative process instead of air from the atmosphere being allowed into the build chamber, a separate cylinder of gas, for instance nitrogen, can be used, which will enable a dry surface to the object after post exposure due to the absence of oxygen.

Separation of the liquids (resin, resin wash cleaner or water) is enabled by making the LCD screen surface low energy with silane-based low-energy coating while making the resin valve and piston face surfaces attractive with high surface energy coatings.

In a further embodiment of the invention the photopolymer can be replaced a particle-rich photopolymer slurry and the process carried out in the same manner. This enables the printer to make both ceramic and metal parts by selective curing of a particle rich slurry. The pressurising of the container enables the very dense slurry to enter the cylinder without creating delamination of the recently built layer as the force is now longer the platform lifting from the screen, but the slurry pushing the part up away from the screen.

In a further embodiment of this invention the manner as previously described of pressurising the build container and the using nitrogen as the gas to remove the liquid makes it ideally suited as a 3D printer for the gravity-less environment in space.

This type of 3D printer is ideally suited to be used in space as visible light enables safe use of screens and useful penetration in particle-rich slurries to pre-determined depths. Slurries also operate better in space as they remain homogeneous, as gravity creates particle slumping. The use of very high-resolution virtual reality screens can deliver <10-micron resolutions in the final object. The process is very scalable by using lots of high-resolution screens or single large ones on a single build chamber. The process operates without wear to any part apart from the linear drive, so the printers can last for extremely long time without repair.

## Claims

1. A stereolithographic 3D printer comprising:
a build vessel (108) having:
at least one side wall;
a print platform (105); and
a visual display screen (107);
wherein the at least one side wall, the print platform and the visual display screen define a sealed build chamber therebetween, the print platform or visual display screen being movable within the build vessel, allowing the volume of the sealed build chamber to be varied,
a reservoir vessel (101) defining a reservoir chamber for housing a photopolymer (100), the
build chamber being coupled to the reservoir chamber by a valve (103) to allow the
photopolymer to move between the build chamber and the reservoir chamber,
**characterised in that**
the build layer thickness is determined by pressure solely on the reservoir chamber with the build chamber volume freely adjustable.

2. A 3D printer of claim 1 where the photopolymer is delivered into the build chamber by pressure on the reservoir chamber containing the photopolymer.

3. A 3D printer of claim 2, wherein the photopolymer within the reservoir chamber is pressurised by a piston, which acts to reduce the volume of the reservoir chamber.

4. A 3D printer of any preceding claim where the build chamber does not have an air blanket covering the photopolymer during the build process.

5. A 3D printer of any preceding claim where the print platform is movable within the build vessel and creates a seal at its perimeter; or
where the visual display screen is movable within the build vessel and creates a seal at its perimeter.

6. A 3D printer of any preceding claim wherein the visual display screen is an LCD screen; and optionally
wherein the LCD screen is illuminated by an LED backlight.

7. A 3D printer of any preceding claim wherein the visual display screen enables the passage of visible or near-visible UV light.

8. A 3D printer of any preceding claim wherein the photopolymer is a particle rich slurry; and optionally
wherein the particles are metal or ceramic.

9. A 3D printer of any preceding claim,
wherein the 3D printer comprises a further valve located in the at least one side wall, configured to allow a fluid to enter the build chamber,
wherein, in use, entry of the fluid into the build chamber forces photopolymer from the build chamber into the reservoir chamber.

10. A 3D printer of any preceding claim wherein the build chamber can be filled with a wash fluid to solubilise the photopolymer.

11. A 3D printer of any preceding claim wherein the build chamber can be filled with water or gas to enable a printed part to be post exposed in the same chamber; and optionally wherein the same display screen that exposed the photopolymer to create the object can be used to post-expose the object, whether under water or gas.

12. A method for creating 3D objects, the method comprising:
providing a 3D printer according to any of claims 1 to 11;
exposing a layer of photopolymer within the build chamber to light emitted by the visual display screen;
increasing the volume of the build chamber sequentially;
exposing a further layer of photopolymer within the build chamber to light emitted by the visual display screen, **characterised in that**, when increasing the volume of the build chamber sequentially, the build layer thickness is determined by pressure solely on the reservoir chamber with the build chamber volume freely adjustable.

13. A method according to claim 12, wherein the volume of the build chamber is increased by allowing photopolymer to enter the build chamber from the reservoir chamber.

14. A method according to claim 12 or 13, the method further comprising allowing a pressurised gas into the build chamber to force photopolymer from the build chamber into the reservoir chamber.

15. A method according to any of claims 12 to 14, the method further comprising filling the build chamber with a wash fluid to solubilise the photopolymer; and/or
the method further comprising filling the build chamber with water or gas to enable the part to be post exposed in the same chamber.

## Patentansprüche

1. Stereolithografischer 3D-Drucker, umfassend:
einen Baubehälter (108), der Folgendes aufweist:
mindestens eine Seitenwand;
eine Druckplattform (105); und
einen visuellen Anzeigebildschirm (107);
wobei die mindestens eine Seitenwand, die Druckplattform und der visuelle Anzeigebildschirm eine abgedichtete Baukammer dazwischen definieren, wobei die Druckplattform oder der visuelle Anzeigebildschirm innerhalb des Baubehälters beweglich ist, was ermöglicht, dass das Volumen der abgedichteten Baukammer verändert werden kann,
einen Vorratsbehälter (101), der eine Vorratskammer zum Aufnehmen eines Photopolymers (100) definiert, wobei die Baukammer durch ein Ventil (103) mit der Vorratskammer gekoppelt ist, um zu ermöglichen, dass das Photopolymer zwischen der Baukammer und der Vorratskammer bewegt werden kann, **dadurch gekennzeichnet, dass**
die Bauschichtstärke allein durch den Druck auf die Vorratskammer bestimmt wird, wobei das Volumen der Baukammer frei einstellbar ist.

2. 3D-Drucker nach Anspruch 1, wobei das Photopolymer durch Druck auf die Vorratskammer, die das Photopolymer enthält, in die Baukammer zugeführt wird.

3. 3D-Drucker nach Anspruch 2, wobei das Photopolymer in der Vorratskammer durch einen Kolben unter Druck gesetzt wird, der wirkt, um das Volumen der Vorratskammer zu reduzieren.

4. 3D-Drucker nach einem vorherigen Anspruch, wobei die Baukammer während des Bauprozesses keine Luftschicht aufweist, die das Photopolymer abdeckt.

5. 3D-Drucker nach einem vorherigen Anspruch, wobei die Druckplattform innerhalb des Baubehälters beweglich ist und an ihrem Umfang eine Dichtung erzeugt; oder
wobei der visuelle Anzeigebildschirm innerhalb des Baubehälters beweglich ist und eine Abdichtung am Rand des Behälters schafft.

6. 3D-Drucker nach einem vorherigen Anspruch, wobei der visuelle Anzeigebildschirm ein LCD-Bildschirm ist; und optional
wobei der LCD-Bildschirm durch eine LED-Hintergrundbeleuchtung beleuchtet wird.

7. 3D-Drucker nach einem vorherigen Anspruch, wobei der visuelle Anzeigebildschirm den Durchgang von sichtbarem oder nahezu sichtbarem UV-Licht ermöglicht.

8. 3D-Drucker nach einem vorherigen Anspruch, wobei das Photopolymer eine partikelreiche Aufschlämmung ist; und optional
wobei die Partikel aus Metall oder Keramik sind.

9. 3D-Drucker nach einem vorherigen Anspruch,
wobei der 3D-Drucker ein weiteres Ventil umfasst, das sich in der mindestens einen Seitenwand befindet und konfiguriert ist, um zu ermöglichen, dass ein Fluid in die Baukammer eintritt,
wobei in Verwendung ein Eintritt des Fluids in die Baukammer das Photopolymer aus der Baukammer in die Vorratskammer drückt.

10. 3D-Drucker nach einem vorherigen Anspruch, wobei die Baukammer mit einer Waschflüssigkeit gefüllt werden kann, um das Photopolymer aufzulösen.

11. 3D-Drucker nach einem vorherigen Anspruch, wobei die Baukammer mit Wasser oder Gas gefüllt werden kann, um zu ermöglichen, dass ein bedrucktes Teil in derselben Kammer nachbelichtet werden kann; und optional
wobei derselbe Anzeigebildschirm, der das Photopolymer zur Herstellung des Objekts belichtet hat, zur Nachbelichtung des Objekts verwendet werden kann, sei es unter Wasser oder unter Gas.

12. Verfahren zur Herstellung von 3D-Objekten, das Verfahren umfassend:
Bereitstellen eines 3D-Druckers nach einem der Ansprüche 1 bis 11;
Belichten einer Schicht aus Photopolymer in der Baukammer mit Licht, das von dem visuellen Anzeigebildschirm ausgestrahlt wird;
nach und nach Vergrößern des Volumens der Baukammer;
Belichten einer weiteren Schicht aus Photopolymer innerhalb der Baukammer mit Licht, das von dem visuellen Anzeigebildschirm ausgestrahlt wird, **dadurch gekennzeichnet, dass** bei aufeinanderfolgender Vergrößerung des Volumens der Baukammer die Stärke der Bauschicht allein durch den Druck auf die Vorratskammer bestimmt wird, wobei das Volumen der Baukammer frei einstellbar ist.

13. Verfahren nach Anspruch 12, wobei das Volumen der Baukammer vergrößert wird, indem das Photopolymer aus der Vorratskammer in die Baukammer eintritt.

14. Verfahren nach Anspruch 12 oder 13, wobei das Verfahren ferner ein Einlassen eines unter Druck stehenden Gases in die Baukammer umfasst, um das Photopolymer aus der Baukammer in die Vorratskammer zu drücken.

15. Verfahren nach einem der Ansprüche 12 bis 14, wobei das Verfahren ferner ein Füllen der Baukammer mit einer Waschflüssigkeit umfasst, um das Photopolymer aufzulösen; und/oder das Verfahren ferner ein Füllen der Baukammer mit Wasser oder Gas umfasst, damit das Teil in derselben Kammer nachbelichtet werden kann.

## Revendications

1. Imprimante 3D stéréolithographique comprenant :
une cuve de construction (108) ayant :
au moins une paroi latérale ;
une plateforme d'impression (105) ; et
un écran d'affichage visuel (107) ;
dans lequel l'au moins une paroi latérale, la plateforme d'impression et l'écran d'affichage visuel définissent une chambre de construction étanche entre eux, la plateforme d'impression ou l'écran d'affichage visuel étant mobile à l'intérieur de la cuve de construction,
permettant de faire varier le volume de la chambre de construction étanche,
une cuve réservoir (101) définissant une chambre réservoir pour loger un photopolymère (100), la chambre de construction étant couplée à la chambre réservoir par une valve (103) pour permettre au photopolymère de se déplacer entre la chambre de construction et la chambre réservoir, **caractérisée en ce que** l'épaisseur de la couche de construction est déterminée par la pression uniquement sur la chambre du réservoir avec le volume de la chambre de construction étant librement réglable.

2. Imprimante 3D selon la revendication 1, dans laquelle le photopolymère est délivré dans la chambre de construction par pression sur la chambre réservoir contenant le photopolymère.

3. Imprimante 3D selon la revendication 2, dans laquelle le photopolymère à l'intérieur de la chambre réservoir est pressurisé par un piston, qui agit pour réduire le volume de la chambre réservoir.

4. Imprimante 3D selon l'une quelconque des revendications précédentes, dans laquelle la chambre de construction n'a pas de couverture d'air recouvrant le photopolymère pendant le processus de construction.

5. Imprimante 3D selon l'une quelconque des revendications précédentes, dans laquelle la plateforme d'impression est mobile à l'intérieur de la cuve de construction et crée un joint au niveau de son périmètre ; ou
là où l'écran d'affichage visuel est mobile à l'intérieur de la cuve de construction et crée un joint au niveau de son périmètre.

6. Imprimante 3D selon l'une quelconque des revendications précédentes, dans laquelle l'écran d'affichage visuel est un écran LCD ; et éventuellement
dans laquelle l'écran LCD est éclairé par un rétroéclairage LED.

7. Imprimante 3D selon l'une quelconque des revendications précédentes, dans laquelle l'écran d'affichage visuel permet le passage de la lumière UV visible ou presque visible.

8. Imprimante 3D selon l'une quelconque des revendications précédentes, dans laquelle le photopolymère est une suspension riche en particules ;
et éventuellement
dans laquelle les particules sont en métal ou en céramique.

9. Imprimante 3D selon l'une quelconque des revendications précédentes,
dans laquelle l'imprimante 3D comprend une autre valve située dans l'au moins une paroi latérale, configurée pour permettre à un fluide d'entrer dans la chambre de construction,
dans laquelle, lors de l'utilisation, l'entrée du fluide dans la chambre de construction force le photopolymère depuis la chambre de construction dans la chambre de réservoir.

10. Imprimante 3D selon l'une quelconque des revendications précédentes, dans laquelle la chambre de construction peut être remplie d'un fluide de lavage pour solubiliser le photopolymère.

11. Imprimante 3D selon l'une quelconque des revendications précédentes, dans laquelle la chambre de construction peut être remplie d'eau ou de gaz pour permettre à une pièce imprimée d'être post-exposée dans la même chambre ; et éventuellement
dans laquelle le même écran d'affichage qui a exposé le photopolymère pour créer l'objet peut être utilisé pour post-exposer l'objet, que ce soit sous l'eau ou sous un gaz.

12. Procédé de création d'objets 3D, le procédé comprenant :
la fourniture d'une imprimante 3D selon l'une quelconque des revendications 1 à 11 ;
l'exposition d'une couche de photopolymère à l'intérieur de la chambre de construction à la lumière émise par l'écran d'affichage visuel ;
l'augmentation séquentielle du volume de la chambre de construction ;
l'exposition d'une autre couche de photopolymère à l'intérieur de la chambre de construction à la lumière émise par l'écran d'affichage visuel, **caractérisée en ce que**, lors de l'augmentation séquentielle du volume de la chambre de construction, l'épaisseur de la couche de construction est déterminée par une pression uniquement sur la chambre réservoir avec le volume de la chambre de construction étant librement réglable.

13. Procédé selon la revendication 12, dans lequel le volume de la chambre de construction est augmenté en permettant au photopolymère d'entrer dans la chambre de construction à partir de la chambre réservoir.

14. Procédé selon la revendication 12 ou 13, le procédé comprenant en outre l'introduction d'un gaz sous pression dans la chambre de construction pour forcer le photopolymère depuis la chambre de construction dans la chambre réservoir.

15. Procédé selon l'une quelconque des revendications 12 à 14, le procédé comprenant en outre le remplissage de la chambre de construction avec un fluide de lavage pour solubiliser le photopolymère ; et/ou
le procédé comprenant en outre le remplissage de la chambre de construction avec de l'eau ou du gaz pour permettre à la pièce d'être post-exposée dans la même chambre.
